# EUROPÄISCHE PATENTSCHRIFT

(11) **EP 0 676 099 B1**
(45) Veröffentlichungstag und Bekanntmachung des Hinweises auf die Patenterteilung: **18.06.1997**
(21) Anmeldenummer: 94900107.7
(22) Anmeldetag: 06.11.1993
(51) Int. Cl.: H03F 3/45, H03F 1/32

(54) **SCHALTUNGSANORDNUNG FÜR EINEN INTEGRIERTEN AUSGANGSVERSTÄRKER**
CIRCUIT ARRANGEMENT FOR AN INTEGRATED OUTPUT AMPLIFIER
CIRCUITERIE POUR UN AMPLIFICATEUR DE SORTIE INTEGRE

(30) Priorität: 19.12.1992 DE 4243009
(43) Veröffentlichungstag der Anmeldung: 11.10.1995
(73) Patentinhaber: TOPHOLM & WESTERMANN APS, DK-3500 Vaerloese (DK)
(72) Erfinder: ANDERSEN, Henning, Haugaard, DK-2970 Horsholm (DK)
(74) Vertreter: Böhmer, Hans Erich, Dipl.-Ing.
(86) Internationale Anmeldenummer: EP9303109
(87) Internationale Veröffentlichungsnummer: WO9415397

(56) Entgegenhaltungen:
- EP-A- 0 121 027
- US-A- 3 582 802
- US-A- 3 946 325
- ELECTRONICS LETTERS Bd. 27, Nr. 20 , 26. September 1991 , ENAGE GB Seiten 1873 - 1875 XP264366 J. SEVENHANS ET AL. 'NOVEL CMOS LINEAR OTA USING FEEDBACK CONTROL ON COMMON SOURCE NODE'
- IEEE JOURNAL OF SOLID-STATE CIRCUITS. Bd. 25, Nr. 2 , April 1990 , NEW YORK US Seiten 555 - 661 XP116701 TING-PING LIU 'A 250 MHz Monolithic Voltage-Controlled Oscillator with Low Temperature Coefficient'

## Beschreibung

Die Erfindung betrifft eine Schaltungsanordnung für einen integrierten Ausgangsverstärker mit zwei im wesentlichen gleichartigen Konstantstromquellen, mit einem integrierten Spannungsverstärker mit zwei Eingängen und zwei Ausgängen und damit gekoppelten im wesentlichen gleichen Ausgangstransistoren und zwei im wesentlichen gleichen negativen Rückkopplungsnetzwerken zwischen den Ausgangstransistoren und den zugeordneten Eingangstransistoren des Spannungsverstärkers.

Derartige hochintegrierte Schaltungen eignen sich besonders für Ausgangsverstärker mit verhaltnismäßig kleiner Leistung, wie sie beispielsweise in Hörgeräten verwendet werden können.

Bekanntlich ändert sich normalerweise die Verstärkung bei sehr kleinen Ausgangsimpedanzen stark mit dem Ausgangsstrom, wenn es sich bei der Ausgangsseitigen Last um eine weitgehend induktive Last handelt, deren Gleichstromwiderstand bei 50 Ohm liegt und deren Wechselstromwiderstand bei 800 Hz etwa 100 Ohm beträgt.

Eine derartige Schaltung ist beispielsweise aus der US PS 4 085 382 bekannt. Dort ist ein direkt gekoppelter integrierter B-Verstärker kleiner Leistung offenbart, der aus einem dreistufigen Zweikanal-Vorverstärker und einem Paar Ausgangstransistoren, je einer für jeden Kanal, besteht. In jedem Kanal ist eine negative Rückkopplungsschleife vorgesehen, die den Kollektor des Transistors der letzten Stufe des Vorverstärkers mit der Basiselektrode der ersten Stufe des Vorverstärkers verbindet und damit den Gleichstrompegel regelt.

Eine negative, restistive Wechselspannungs-Rückkopplungsschleife verbindet jeweils den Kollektor eines Ausgangstransistors mit dem Kollektor des entsprechenden ersten Vorverstärker-Transistors, um so die Verstärk- ungsabhängigkeit des jeweiligen Kanals von dem den Ausgangstransistor durchfließenden Strom zu vermindern. Dies soll zu geringeren Ruheströmen in den Ausgangstransistoren führen.

Dieser Verstärker hat jedoch eine relativ hohe Verstärkung von mehr als 40 dB.

Aufgabenbereich der Erfindung:

Diese Schaltung ist jedoch nicht ohne Probleme. Zunächst benötigt sie zu viele und zu große externe Bauelemente,wie z.B. zwei Kondensatoren im Mikrofarad-Bereich und einen Kondensator im Nanofarad-Bereich für die Stabilisierung.

Ferner ist der Leistungsbedarf zu hoch und die Ausgangsleistung dafür zu gering. Man ist zwar immer bestrebt, den Ruhestrom der Ausgangstransistoren klein zu halten. Verringert man diesen zu stark, dann ergeben sich bei einer Last mit niedriger Impedanz hohe Verzerrungen. Je besser die Ausgangstransistoren in das Sättigungsgebiet ausgesteuert werden, umso weniger geht der Spannungsquelle entnommene Leistung in dem Verstärker verloren.

Bei der bekannten Schaltung erfolgt die Ansteuerung der Ausgangstransistoren passiv, d.h. Uber einen Widerstand und wird niedrig gehalten, um den Ruhestrom zu begrenzen. Das hat aber zur Folge, daß die Sättigung der Ausgangstransistoren zu gering ist. Außerdem ist bei dem bekannten Verstärker das eingangsseitige Rauschen zwar gering, jedoch ist die Gesamtverstärkung hoch, (größer als 40 dB ), so daß das Signal: Rauschverhältnis bei niedriger Verstärkungseinstellung nicht allzu gut ist.

Die Verstärkung der Ausgangsstufe kann jedoch nicht verringert werden, da sonst die Eingangsstufe vor der Ausgangsstufe in die Sättigung gesteuert würde.

Aufgabe der Erfindung ist es, eine Schaltungsanordnung der eingangs genannten Art in der Weise zu verbessern, daß bei weniger externen Bauelementen ein geringerer Ruhestrom, eine hohe Aussteuerbarkeit bei geringen Verzerrungen und dies bei einer mittleren Verstärkung von z.B. 20 bis 30 dB erzielt werden kann.

Dies wird erfindungsgemäß durch die Merkmale des Patentanspruchs 1 erreicht.

Weitere Merkmale der Erfindung sind den weiteren Patentanspruchen zu entnehmen.

Die Erfindung wird nunmehr anhand eines Ausführungsbeispieles in Verbindung mit den beigefügten Zeichnungen näher erläutert:
In den Zeichnungen zeigt:
- Fig. 1: den Verlauf der Verstärkung bei kleinen Signalamplituden als Funktion der an der Last liegenden Spannung für zwei Impedanzwerte im Stand der Technik;
- Fig. 2: ein stark vereinfachtes Prinzipschaltbild des neuen Ausgangsverstärkers;
- Fig. 3: ein vereinfachtes Prinzipschaltbild des Ausgangsverstärkers gemäß der Erfindung und
- Fig. 4: den Verlauf der Verstärkung bei kleinen Signalamplituden als Funktion der an der Last liegenden Spannung für zwei Impedanzwerte bei einer erfindungsgemäß aufgebauten Schaltung.

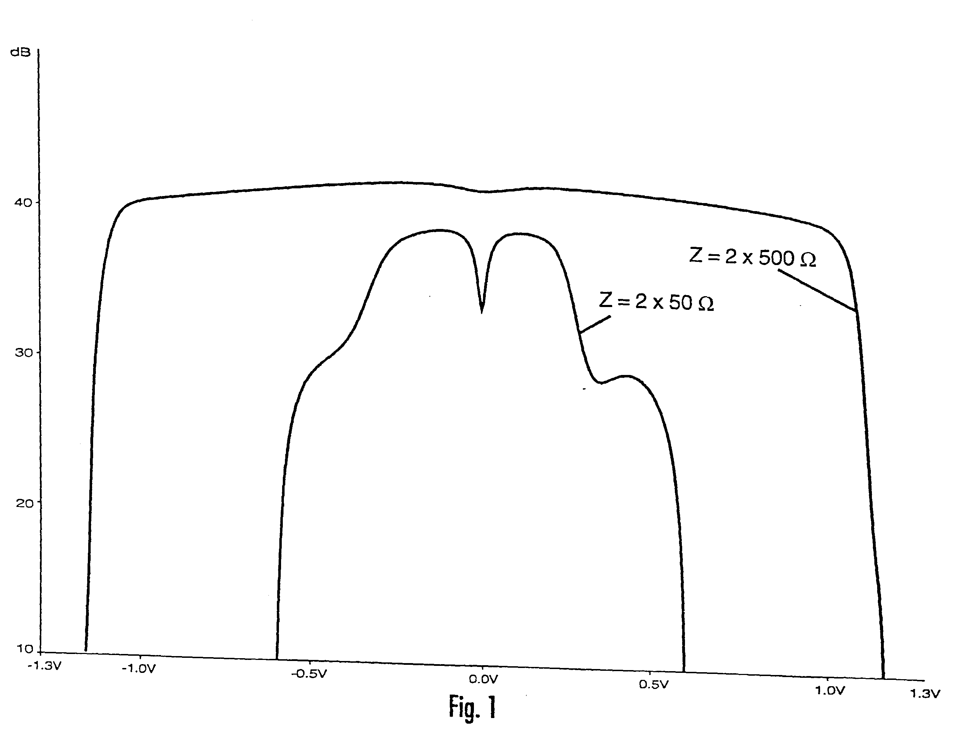

Aus dem in Fig. 1 gezeigten Verlauf der einzelnen Kurven erkennt man daß die Unterschiede zwischen einem Lastwiderstand von 50 Ohm und einem Lastwiderstand von 500 Ohm geradezu drastisch sind. Es muß also möglich sein, diese Charakteristik eines Ausgangsverstärkers zu verbessern.

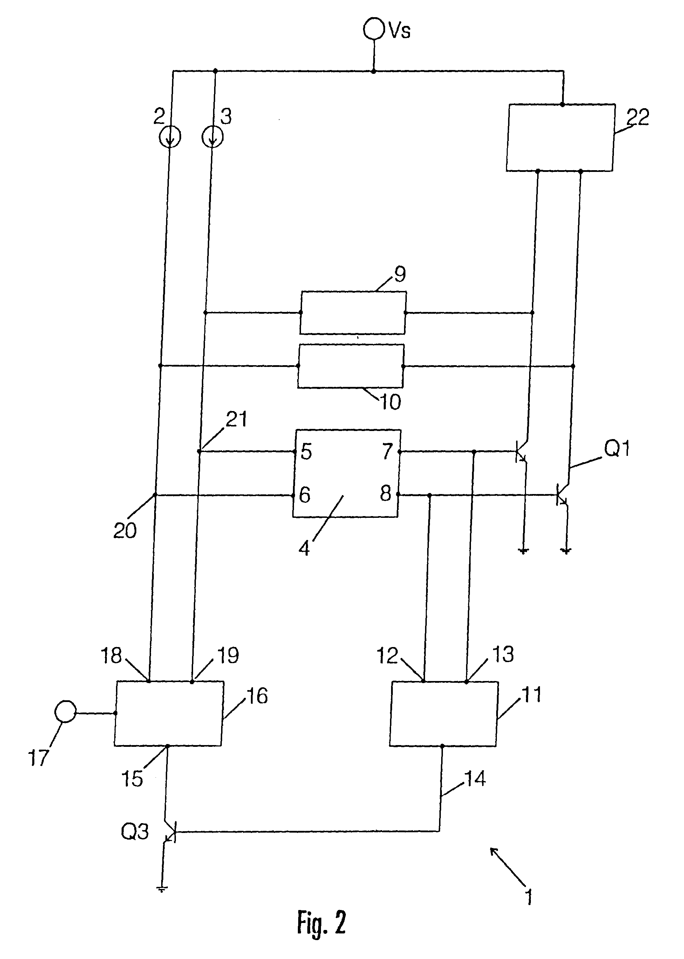

In Fig. 2 ist zunächst das stark vereinfachte Prinzipschaltbild der Erfindung erkennbar. In dem Ausgangsverstärker 1 speist eine Spannungsquelle Vs zwei Konstantstromquellen 2 und 3, die einen Spannungsverstärker 4 mit zwei Eingängen 5 und 6 sowie zwei Ausgängen 7 und 8 speisen. Dieser Spannungsverstärker steuert zwei Leistungstransistoren als Ausgangstransistoren Q1 und Q2 an. Ferner sind dort zwei Rückkopplungsnetzwerke 9 und 10 angeschlossen, die mit den von den Kollektoren der Ausgangstransistoren nach der Last führenden Leitungen verbunden sind. Ein weiteres Rückkopplungsnetzwerk 11 ist am Ausgang des Spannungsverstärkers und den nach den Basiselektroden der Ausgangstransistoren führenden Leitungen mit den beiden Eingängen 12 und 13 angeschlossen. Ferner ist eine Vorspannungsquelle Vv angedeutet.

Der Ausgang 14 des Rückkopplungsnetzwerkes ist mit einem als Stromsenke wirkenden Transistor Q3 an dessen Basiselektrode verbunden. Die Emitterelektrode von Q3 ist mit Masse verbunden. Der Kollektor von Q3 ist an einem Eingang 15 eines Stromaufteilungs-Netzwerkes 16 angeschlossen. Dieses weist außerdem einen Signaleingang 17 auf. An Ausgängen 18 und 19 dieses Stromaufteilungs-Netzwerkes sind zwei parallele Leitungen angeschlossen, die nach den Anschlußpunkten 20 und 21 der von den Konstantstromquellen kommenden Leitungen führen. Der Ausgang der Leistungstransistoren Q1, Q2 ist mit einer Last 22 verbunden, die vorzugsweise die mit einer Mittenanzapfung versehene Primärwicklung eines AusgangsUbertragers ist.

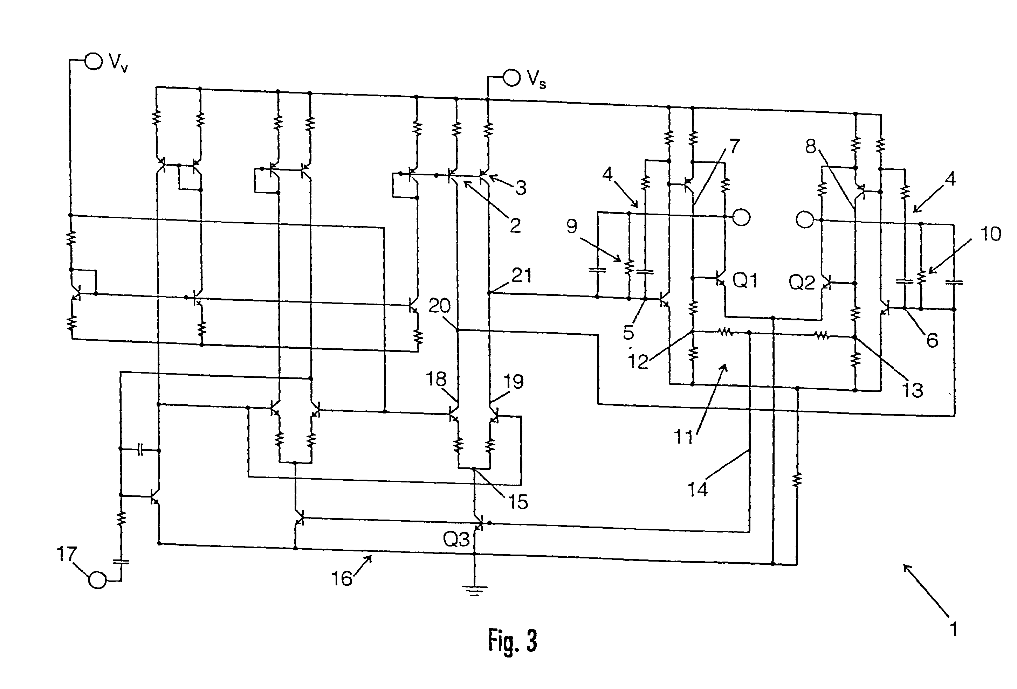

Dieses Prinzipschaltbild soll nunmehr anhand der Fig. 3 näher erläutert werden, wobei gleiche Teile mit gleichen Bezugszeichen versehen sind und daher einer erneuten Aufzählung nicht bedürfen.

Der Ausgangsverstärker hat zwei angenähert gleiche Konstantstromquellen 2 und 3, ein Stromaufteilungsnetzwerk 16, zwei angenähert gleiche Rückkopplungsnetzwerke 9 und 10, einen Spannungsverstärker 4 mit zwei Eingängen und zwei Ausgängen, zwei annähernd gleiche Ausgangstransistoren Q1 und Q2 sowie ein weiteres Rückkopplungsnetzwerk 11 und einen als Stromsenke wirkenden Transistor Q3.

Die Konstantstromquellen 2 und 3 liefern einen Konstantstrom an die Knotenpunkte 20 und 21. Der Transistor Q3 zieht Strom über den Knotenpunkt oder Eingang 15 des Stromaufteilungsnetzwerkes nach Masse. Dabei wird der Strom zwischen den beiden Zweigen 18 und 19 aufgeteilt.

Das Aufteilungsverhältnis wird durch das Eingangssignal an der Eingangsklemme 17 in der Weise gesteuert, daß die Differenz der Ströme in den beiden Zweigen 18 und 19 proportional dem an der Eingangsklemme 17 liegenden Signal ist. Bei einer hohen Signalamplitude am Eingang 17 wird der in dem Zweig 18 fließende Strom zu Null, während der gesamte durch den Transistor Q3 fließende Strom durch den Zweig 19 fließt. Bei einer entsprechend hohen entgegengesetzten Signalamplitude am Eingang 17 werden sich die entgegengesetzten Verhältnisse einstellen, d.h. der gesamte durch den Transistor Q3 fließende Strom wird in dem Zweig 18 fließen, während der Zweig 19 keinen Strom führt.

Der Spannungsverstärker 4 hat eine nicht invertierende Verstärkung derart, daß die Summe der Ausgangsspannungen durch die Summe der Eingangsspannungen bestimmt wird. Der Verstärker hat außerdem noch eine differentielle Verstärkung derart, daß die Differenz der Spannungen an den Ausgänge 7 und 8 durch die Differenz der Spannungen an den Eingängen 5 und 6 bestimmt ist.

Die Ausgangstransistoren Q1 und Q2 werden an ihren Basiselektroden gesteuert, die Emitterelektroden sind mit Masse verbunden, und die Kollektoren sind an der Last angeschlossen.

Eine negative Rückkopplung wird Uber die Rückkopplungsnetzwerke 9 und 10 erzielt. Jedes dieser Netzwerke setzt die an einem Kollektor auftretende Spannung in einen dem Eingang des Spannungsverstärkers zugeführten Strom um. Diese Anordnung stellt sicher, daß die über der Last liegende Spannung der Differenz der Ströme an den Ausgängen 18 und 19 proportional ist, wodurch die Proportionalität zwischen dem Eingangssignal und der über der Last liegenden Spannung sichergestellt wird.

Das Rückkopplungsnetzwerk 11 hat zwei Eingänge 12 und 13 und einen Ausgang 14. Die Ausgangsspannung dieses Netzwerkes wird durch die mittlere Spannung der Eingangsspannungen an den Klemmen 5 und 6 gesteuert, wobei möglicherweise eine kleine Vorspannung gegeben werden kann.

Die am Ausgang 14 des Rückkopplungsnetzwerkes liegende Spannung wird der Basis des Transistors Q3 zugeführt, wobei hier ein Transistor gleicher Bauart verwendet wird, der höchstwahrscheinlich jedoch andere Größenordnungen aufweist als Q1 und Q2.

Die Rückkopplungsschleife mit dem Rückkopplungsnetzwerk 11 steuert den Kollektorstrom von Q3 und bewirkt damit, daß dieser gleich der Summe der von den Konstantstromquellen 2 und 3 ausgehenden Ströme, zuzüglich der Summe der von den Rückkopplungsnetzwerken 9 und 10 stammenden Ströme ist.

Da die an der Basiselektrode von Q3 liegende Spannung gleich den Basisspannungen an den Ausgangstransistoren Q1 und Q2 ist, wenn kein Eingangssignal vorhanden ist (möglicherweise mit einer kleinen Verschiebung), steuert diese Spannung auch den Ruhestrom von Q1 und Q2. Wenn ein Eingangssignal auftritt, dann weichen die Basisspannungen von Q1 und Q2 vom Wert des Ruhestromes um angenähert gleiche Werte von entgegengesetzter Polarität ab.

Prinzipiell arbeitet diese Schaltung zunächst ohne Begrenzung der Ausgangsleistung, bei der bei gegebener Betriebsspannung und den unvermeidlichen Begrenzungen durch die Schaltung selbst maximal möglichen Leistung. Man könnte jedoch eine derartige Begrenzung der Ausgangsleistung dadurch erreichen, daß man die von den Konstantstromquellen 2 und 3 gelieferten Ströme entsprechend begrenzt. Wird der Strom auf einen Pegel eingestellt, der nicht ausreicht, daß an den Rückkopplungsnetzwerken 9 und 10 die volle Amplitude auftritt, dann wird die Spannungsanplitude am Kollektor von Q1 und Q2 verringert.

Sind die von den Konstantstromquellen gelieferten Ströme hoch genug, dann können die Ausgangstransistoren in die Sättigung gesteuert werden.

In den Prinzipschaltbildern sind die Transistoren Q1, Q2 und Q3 als bipolare NPN-Transistoren dargestellt. Natürlich würde die Schaltung unter Verwendung von PNP-Transistoren genauso arbeiten bei entsprechender Polung der Batterie, jedoch sind normalerweise NPN-Transistoren für integrierte Schaltungen besser geeignet.

Die Schaltungsanordnung würde außerdem ebenso mit N-Kanal- oder P-Kanal-Feldeffekt-Transistoren arbeiten.

Die neue Schaltungsanordnung hat alle eingangs gestellten Forderungen voll erfüllt wie durch Versuche und Messungen bestätigt werden konnte.

Zunächst waren die großen, externen Kondensatoren entbehrlich geworden, wenn man Ausgangsleistung nicht unter den maximal möglichen Wert begrenzt. Eine solche Begrenzung könnte beispielsweise durch Begrenzung der von den Konstantstromquellen gelieferten Ströme erreicht werden. In diesem Fall könnte erforderlichenfalls für die Entkopplung ein Kondensator im Nanofarad-Bereich verwendet werden.

Betrachtet man in diesem Zusammenhang Fig. 1, so zeigt diese das Verhalten einer bekannten Schaltung an einer Last, die beispielsweise aus einer mit einer Mittelanzapfung versehenen Primärwicklung eines Ausgangsübertragers bestehen kann.

Bei einer niedrigen Impedanz von Z = 2 x 50 Ohm, die sich bei tiefen Frequenzen einstellt, weist der Verlauf der Verstärkung eine tiefe Einbuchtung auf. Zudem fällt die Verstärkung nach beiden Seiten bereits bei einer Amplitude von -0,6 V bzw. + o,6 V steil ab.

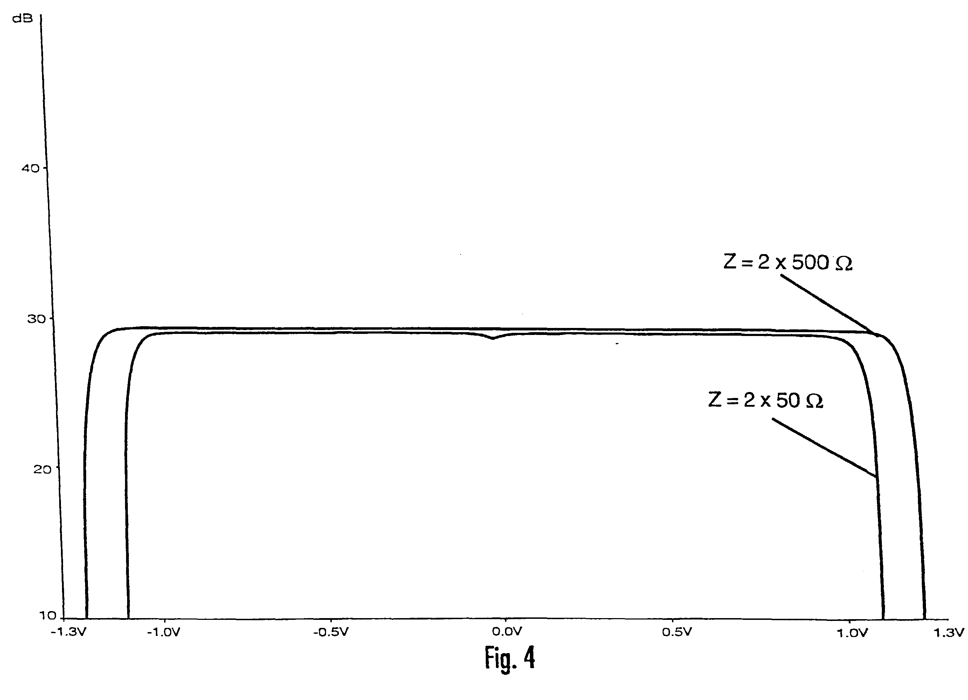

Die Fig. 4 zeigt den Verlauf der Verstärkung bei den gleichen Impedanzen von Z = 2 x 50 Ohm bzw. Z = 2 x 500 Ohm, wie sie mit einem erfindungsgemäß aufgebauten Verstärker erreicht werden kann. Man erkennt sofort, daß die Gesamtverstärkung, wie gefordert, etwas weniger als 30 dB beträgt, dies jedoch sowohl für die niedrige Impedanz von Z = 2 x 50 Ohm, als auch für die höhere Impedenz von Z = 2 x 500 Ohm. Auch ist die Amplitude der an dem Übertrager liegenden Wechselspannung, die zu einer nahezu identischen Verstärkung führt, für die beiden Impedanzen nur geringfügig verschieden.

Damit ist gezeigt, daß die Forderung nach einer ausgeglichenen Verstärkung sowohl bei niedrigen Impedanzen als auch bei hohen Impedanzen einwandfrei erfüllt werden konnte, d.h. daß die Schaltung auch bei niedrigen Impedanzen praktisch frei von Verzerrungen arbeitet.

## Patentansprüche

1. Schaltungsanordnung für einen integrierten Ausgangsverstärker (1) mit zwei im wesentlichen gleichartigen Konstantstromquellen (2, 3), mit einem Spannungsverstärker (4) mit zwei Eingängen (5, 6) und zwei Ausgängen (7, 8) und zwei damit gekoppelten, im wesentlichen gleichen Ausgangstransistoren und zwei im wesentlichen gleichen, eine negative Rückkopplung bewirkenden Rückkopplungsnetzwerken (9, 10) zwischen den Ausgangs transistoren (Q1, Q2) und den zugeordneten Eingangstransistoren des Spannungsverstärkers (4), dadurch gekennzeichnet, daß die Ausgangstransistoren (Q1, Q2) durch den Spannungsverstärker (4) an ihren Basiselektroden aktiv angesteuert werden, während die Emitterelektroden mit Masse verbunden und die Kollektorelektroden an einer Last (22) angeschlossen sind, daß die ersten beiden Rückkopplungsnetzwerke (9, 10) zwischen den Kollektoren der Ausgangstransistoren (Q1, Q2) und den Basiselektroden der zugehörigen Eingangstransistoren des Spannungsverstärkers (4) eingeschaltet sind, daß ein drittes ruhestromsteuerndes Rückkopplungsnetzwerk (11) eingangsseitig (12, 13) an den Basiselektroden der Ausgangstransistoren angekoppelt und ausgangsseitig (14) mit der Basiselektrode eines als Stromsenke wirkenden Transistors (Q3) verbunden ist, dessen Emitterelektrode mit Masse verbunden und dessen Kollektorelektrode mit einem Eingang (15) eines Stromaufteilungsnetzwerkes (16) verbunden ist, das außerdem mit einem Signaleingang (17) versehen ist, und daß das Stromaufteilungsnetzwerk (16) zwei parallele Zweige (18, 19) aufweist, zwischen denen der durch dieses Netzwerk fließende Strom, gesteuert durch das am Signaleingang (17) liegende Signal, aufspaltbar ist, und daß die Zweige (18 bzw. 19) des Stromaufteilungsnetzwerkes (16) einerseits mit den Konstantstromquellen (2 bzw. 3) und andererseits mit den Eingängen (5 bzw. 6) des Spannungsverstärkers (4) verbunden sind.

2. Schaltungsanordnung nach Anspruch 1, dadurch gekennzeichnet, daß eines oder mehrere der Rückkopplungsnetzwerke aus passiven, resistiven Bauelementen bestehen.

3. Schaltungsanordnung nach Anspruch 1 und 2, dadurch gekennzeichnet, daß die Ausgangsleistung des Ausgangsverstärkers (1) durch Begrenzung der von den Konstantstromquellen (2, 3) gelieferten Ströme auf einen geringeren Wert als den Maximalwert begrenzbar ist.

## Claims

1. Circuit arrangement for an integrated output amplifier (1), with two essentially identical constant current sources (2, 3), a voltage amplifier (4) with two inputs (5, 6) and two outputs (7, 8) and two essentially identical output transistors coupled with these, as well as two essentially identical feedback networks (9, 10) producing negative feedback which are connected between the output transistors (Q1, Q2) and the assigned input transistors of the voltage amplifier (4), characterized in that the output transistors (Q1, Q2) are actively driven at their base electrodes by the voltage amplifier (4), while the emitter electrodes are connected to ground and the collector electrodes to a load (22), in that the first two feedback networks (9, 10) are connected between the collectors of the output transistors (Q1, Q2) and the base electrodes of the corresponding input transistors of the voltage amplifier (4), in that a third feedback network (11) which controls the closed-circuit current is connected on the input side (12, 13) to the base electrodes of the output transistors and on the output side (14) with the base electrode of a transistor (Q3) acting as a current sink, whereby the emitter electrode of the latter is connected with ground and the collector electrode with an input (15) of a current splitting network (16), whereby said current splitting network is also provided with a signal input (17), and in that the current splitting network (16) has two parallel branches (18, 19) between which the current flowing through this network can be split, whereby said current is controlled by the signal at the signal input (17), and in that the branches (18 and 19) of the current splitting network (16) are connected on the one hand with the constant current sources (2 and 3) and on the other hand with the inputs (5 and 6) of the voltage amplifier (4).

2. Circuit arrangement in accordance with claim 1, characterized in that one or more of the feedback networks consist of passive, resistive components.

3. Circuit arrangement in accordance with claims 1 and 2, characterized in that the output power of the output amplifier (1) can be limited to a lower value than the maximum value by limiting the currents supplied by the constant current sources (2, 3).

## Revendications

1. Circuit pour un amplificateur de sortie intégré (1) avec deux sources de courant constant (2, 3) pour l'essentiel identiques, avec un amplificateur de tension (4) avec deux entrées (5, 6) et deux sorties (7, 8) et deux transistors de sortie pour l'essentiel identiques, couplés à celles-ci et deux circuits de rétroaction (9, 10), pour l'essentiel identiques, produisant une rétroaction négative entre les transistors de sortie (Q1, Q2) et les transistors d'entrée correspondants de l'amplificateur de tension (4), caractérisé en ce que les transistors de sortie (Q1, Q2) sont pilotés activement par l'amplificateur de tension (4) à leurs électrodes de base, tandis que les électrodes d'émetteur sont reliées à la masse et que les électrodes de collecteur sont raccordées à une charge (22), en ce que les deux premiers circuits de rétroaction (9, 10) entre les collecteurs des transistors de sortie (Q1, Q2) et les électrodes de base des transistors d'entrée correspondants de l'amplificateur de tension (4) sont en circuit, en ce qu'un troisième circuit de rétroaction (11) à courant de repos est relié en entrée (12, 13) aux électrodes de base des transistors de sortie et en sortie (14) à l'électrode de base d'un transistor (Q3) fonctionnant en abaisseur de courant, dont l'électrode d'émetteur est reliée à la masse et dont l'électrode de collecteur est reliée à une entrée (15) d'un circuit de répartition du courant (16), muni également d'une entrée de signaux (17) et en ce que le circuit de répartition du courant (16) présente deux branches parallèles (18, 19) entre lesquelles le courant traversant ce circuit, modulé par le signal présent à l'entrée de signaux (17), peut être séparé, et en ce que les branches (18 ou 19) du circuit de répartition du courant (16) sont reliées d'une part aux sources de courant constant (2 ou 3) et d'autre part aux entrées (5 ou 6) de l'amplificateur de tension (4).

2. Circuit selon la revendication 1, caractérisé en ce qu'un ou plusieurs des circuits de rétroaction sont constitués de composants résistifs passifs.

3. Circuit selon l'une et l'autre des revendications 1 et 2, caractérisé en ce que la puissance de sortie de l'amplificateur de sortie (1) peut être limitée par limitation des courants fournis par les sources de courant constant (2, 3) à une valeur inférieure à la valeur maximale.
